Europäisches Patentamt

European Patent Office

Office européen des brevets

(19)

(11) EP 0 849 808 A2

## EUROPEAN PATENT APPLICATION

(12)

(43) Date of publication:
24.06.1998 Bulletin 1998/26

(51) Int. Cl.⁶: $H01L\ 31/0216$, $H01L\ 31/0224$

(21) Application number: 97122437.3

(22) Date of filing: 18.12.1997

(84) Designated Contracting States:
AT BE CH DE DK ES FI FR GB GR IE IT LI LU MC
NL PT SE
Designated Extension States:
AL LT LV MK RO SI

(30) Priority: 20.12.1996 JP 341002/96

(71) Applicant:
NIPPON SHOKUBAI CO., LTD.
Chuo-ku, Osaka-shi, Osaka-fu 541 (JP)

(72) Inventors:
• Takeda, Mitsuo
Sanda-shi, Hyogo 669-13 (JP)
• Ueda, Yumiko
Yamatotakada-shi, Nara 653 (JP)
• Yoshii, Seiji
Sanda-shi, Hyogo 669-13 (JP)

(74) Representative:
Glawe, Delfs, Moll & Partner
Patentanwälte
Postfach 26 01 62
80058 München (DE)

(54) **Photoelectric conversion element**

(57) This invention provides a photoelectric conversion element which is rarely affected by environmental changes and has high and stable photoelectric conversion characteristics without impairing its economical advantage as a merit. The photoelectric conversion element comprises photoelectric conversion cells each of which has at least two electrodes and a silicon layer as electrically connected to said electrodes, and this element is characterized in that an infrared rays shielding film containing an infrared rays reflective and/or absorptive material is formed on a light input side of said photoelectric conversion element.

**Fig. 1**

EP 0 849 808 A2

**Description**

**BACKGROUND OF THE INVENTION**

A. TECHNICAL FIELD

The present invention relates to a photoelectric conversion element capable of converting optical energy into electrical energy in the field of solar cells, holograms and the like. More specifically, it relates to a photoelectric conversion element which uses silicon and has high photoelectric conversion efficiency and durability.

B. BACKGROUND ART

A photoelectric conversion element using silicon is now attracting much attention as an inexpensive solar cell due to its excellent economic performance resulted by the improvement of photoelectric conversion efficiency. However, it has such a problem that its photoelectric conversion properties, that is, optical voltage and optical current, are changed by a rise of the temperature of the photoelectric conversion element, thereby reducing its output at the time of use, or its photoelectric conversion properties deteriorate when it is used in an extreme environment such as high temperatures or drastic temperature variations. Particularly when it is used outdoors as a solar cell, it is subjected not only to drastic temperature variations but also to wind and acid rain at a high humidity. Therefore, a photoelectric conversion element which can operate stably in such an extreme environment has been desired. It has been strongly desired especially from inexpensive amorphous silicon solar cells which can be reduced in thickness with ease.

As means of suppressing a reduction in photoelectric conversion properties due to a temperature rise, there is proposed a method of changing the structure of an amorphous silicon solar cell such that it can transmit infrared rays which is the cause of such a temperature rise (JP-A-55044793). Since a material layer having a high refractive index must be formed in this method and the structure of the silicon solar cell is complex, an economic advantage which is the feature of amorphous silicon may be lost.

JP-A-59112660 discloses a method of providing water resistance and scratch resistance to a solar cell which consists of a metal electrode, amorphous semiconductor layer and transparent electrode formed on a substrate in the mentioned order by further forming an organic layer and an inorganic layer on the transparent electrode sequentially. However, this method does not take a countermeasure against an output reduction caused by a temperature rise.

**SUMMARY OF THE INVENTION**

A. OBJECTS OF THE INVENTION

An object of the present invention is to provide a silicon-based photoelectric conversion element which is rarely affected by environmental changes and has high and stable photoelectric conversion properties without impairing its economical advantage as a merit.

B. DISCLOSURE OF THE INVENTION

A photoelectric conversion element, according to the present invention, comprises photoelectric conversion cells each of which has at least two electrodes and a silicon layer as electrically connected to the electrodes, and this photoelectric conversion element is characterized in that an infrared rays shielding film containing an infrared rays reflective and/or absorptive material is formed on a light input side of the photoelectric conversion element.

In the above photoelectric conversion element, the infrared rays reflective and/or infrared absorption material is preferably a metal oxide.

The infrared rays shielding film is preferably a coating film which is obtained by a process including the step of applying a coating composition including an infrared rays reflective and/or absorptive material and a binder. The coating film is preferably a film cured or cross-linked by at least one of heat, moisture, electron beam and ultraviolet rays after the application of the coating composition.

These and other objects and advantages of the present invention will be more fully apparent from the following detailed disclosure.

**BRIEF DESCRIPTION OF THE DRAWINGS**

Fig. 1 is a sectional view of a PIN type photoelectric conversion element used in Examples and Comparative Examples.

2

Fig. 2 is a schematic diagram of a measuring instrument used in Examples and Comparative Examples;

Fig. 3 is a graph showing time changes in the surface temperatures of elements of Example 1 and Comparative Example 1.

Fig. 4 is a graph showing the optical characteristic properties of films used in Example 1 and Comparative Example 1.

## DETAILED DESCRIPTION OF THE INVENTION

The photoelectric conversion element of the present invention comprises photoelectric conversion cells each of which has at least two electrodes and a silicon layer as electrically connected to the electrodes. The photoelectric conversion cell is the minimum unit of the photoelectric conversion element. That is, one or more photoelectric conversion cells constitute the photoelectric conversion element. The photoelectric conversion element of the present invention may be one photoelectric conversion cell, a module consisting of a plurality of the cells electrically interconnected in series and/or parallel, or an array consisting of a plurality of the modules, or a photoelectric conversion system consisting of a plurality of the arrays. As a matter of course, it may have photoelectric conversion cells integrated on a single substrate (such as an integrated solar cell).

Illustrative examples of the photoelectric conversion system include flat panel type solar power generation systems such as fixed array type, semi-fixed array type, and tracking type; transmission condensing type such as panel tracking type and turn table type solar power generation systems; reflective condensing type solar power generation systems such as fixed focal point tracking type and moving focal point tracking type; and other conventionally known natural illumination solar power generation system.

Conventionally known amorphous silicon solar cells such as PN-coupled type, PIN-coupled type, Schottky barrier type and insulating layer-use Schottky barrier type, polycrystalline silicon solar cells, single crystalline silicon solar cells and the like are included in the scope of the photoelectric conversion element of the present invention.

As for the structure of the photoelectric conversion element, for example, the photoelectric conversion element of the present invention comprises (1) a metal electrode, silicon layer and transparent electrode formed on a desired transparent or opaque substrate in the mentioned order, (2) a transparent electrode, silicon layer and metal electrode formed on a transparent substrate in the mentioned order, or the like. Illustrative examples of the transparent substrate include (inorganic) glasses, plastic sheets, plastic films and the like. When a plastic film is used as a substrate, a photoelectric conversion element having excellent flexibility can be obtained.

The infrared rays shielding film in the present invention is formed on the light input side of the photoelectric conversion element. Since the infrared rays shielding film needs to transmit light having highly sensitive range of silicon in photoelectric conversion efficiency, it must have a high transmission of light having the wavelength of that sensitivity range (to be referred to as "photoelectric conversion effective wavelength range" hereinafter). On the other hand, since visible rays and near infrared rays having a wavelength of 800 nm to 2.5 $\mu$m cause a temperature rise in the case of light having a wavelength of 800 nm or more, particularly the sunlight, they must be shut out. A film, displaying excellent transmittance to rays to which silicon is the most sensitive, but shutting out infrared rays including near infrared rays which cause a temperature rise, is formed on the light input side of the photoelectric conversion element, thereby making it possible to suppress a temperature rise in the photoelectric conversion element and protect it from rain, steam, dust and the like.

Therefore, the infrared rays shielding film preferably has the following optical properties.

(1) It preferably has an average transmittance $TV_1$ of light having a wavelength of 380 nm to 1 $\mu$m of 60% or more, more preferably 80% or more.

(2) It preferably has an average transmittance $TIR_1$ of light having a wavelength of 1 to 2 $\mu$m of less than 60%, more preferably less than 40%.

(3) It preferably has an average transmittance $TV_2$ of light having a wavelength of 380 to 780 $\mu$m of more than 85%, particularly preferably more than 92%.

(4) It preferably has an average transmittance $TIR_2$ of light having a wavelength of 1 to 1.5 $\mu$m of less than 60%, particularly preferably less than 30%.

The transmittance means total light transmittance and the average transmittance of light having each wavelength range means the ratio of the quantity of transmitted light to the quantity of incident light having a predetermined wavelength range measured by a spectrophotometer. As the spectrophotometer may be used a spectrophotometer which satisfies requirements specified in Paragraphs 3.2 and 4.2 of JIS R 3106-1985, such as a trade UV-VIS-NIR-Recording spectrophotometer (UV-3100) in which an integrating sphere attachment (ISR-3100) manufactured by Shimadzu Corp. is installed in a sample chamber.

The higher the transmittance of a photoelectric conversion effective wavelength range the better the infrared rays shielding film is. There are a variety of infrared rays shielding films including a transparent film having a high transmittance and substantially no haze such as transparent glass, and a film having a large haze value but a high total light transmittance, that is, excellent diffuse transmission, such as frosted glass. The haze value is preferably 0 to 10%, particularly preferably 0 to 5% from a view point of high transparency. When the film has a too large haze value, its diffusivity of incident light becomes high, whereby there may be a loss in the thermal conversion of visible rays in the photoelectric conversion element.

The structure and form of the infrared rays shielding film are not particularly limited. For example, (A) an infrared rays shielding film is formed directly on a photoelectric conversion element, and (B) an infrared rays shielding film is formed on a substrate having a high transmittance of visible rays, such as a plastic film, sheet, glass or the like.

In the case of (A), when a photoelectric conversion element has a metal electrode, silicon layer and transparent electrode formed on an insulated substrate in the mentioned order, an infrared rays shielding film may be formed on the transparent electrode directly or through a transparent intermediate layer. Alternatively, when a photoelectric conversion element has a transparent electrode, amorphous silicon layer and metal electrode formed on a transparent substrate such as glass, an infrared rays shielding film may be formed on the transparent substrate or between the transparent substrate and the transparent electrode as an intermediate layer.

When the above photoelectric conversion element is sealed by a transparent resin, an infrared rays shielding film may be formed on the sealing resin.

It is important that the infrared rays shielding film should contain an infrared rays reflective and/or absorptive material (may be referred to as "infrared rays shielding material" hereinafter).

The infrared rays shielding material refers to a material which can absorb and/or reflect infrared rays, preferably near infrared rays (780 nm to 2.5 $\mu$m). More preferably, the infrared rays shielding material has a higher transmittance of visible rays than that of near infrared rays. To be concrete, when the infrared rays shielding film is formed under desired conditions, it has the following relationship between the maximum value $TV_{max}$ of the total light transmittance of light having a wavelength of 380 to 780 nm and the maximum value TIRmax of the total light transmittance of light having a wavelength of 780 nm to 2.5 $\mu$m.

$$TV_{max} \ (\%) > TIR_{max} \ (\%)$$

When the transmittances of light having wavelengths of 1.5 $\mu$m and 1.2 $\mu$m represented by $T_{1.5}$ (%) and $T_{1.2}$ (%), respectively, preferably $TV_{max}$ (%) > $T_{1.5}$ (%), more preferably $TV_{max}$ (%) > $T_{1.2}$ (%). When an infrared rays shielding film is formed from the infrared rays shielding material at a rate of 10 g per $m^2$, the material preferably has an ability of $TV_{max}$ (%) > {$TIR_{max}$ (%) - 30 (%)}, particularly preferably $TV_{max}$ (%) > {$TIR_{max}$ (%) - 50 (%)}. As for the measurement of film transmittance, a film is formed on a transparent quartz glass plate and its transmittance of visible rays to near infrared rays (380 nm to 2.5 $\mu$m) is measured using the above-described spectrophotometer based on a quartz glass plate having no film formed thereon (having a transmittance of 100% for each wavelength range).

The feature of the present invention is that the infrared rays shielding film contains an infrared rays shielding material. JP-A-58082578 teaches that only a desired optical element is transmitted to a solar cell element by a multi-layer structure consisting of materials having different refractive indices, such as $SiO_2$ and $TiO_2$. The selection of a desired optical element which has been impossible with each material only is made possible by combining a plurality of materials having different refractive indices, which is different from the technical idea of the present invention. In the present invention, a material capable of shutting out infrared rays by itself is contained as a constituent component of an infrared rays shielding film. Since the object of shutting out infrared rays can be attained by this layer alone, the infrared rays shielding film in the present invention is much more economical than a multi-layer film. Further, since any film forming method can be selected according to the heat resistance, chemical resistance, solvent resistance and the like of a material forming the film, the film has a wide application range.

The composition of the infrared rays shielding film is not particularly limited if it contains an infrared rays shielding material. However, it may be:

(1) a film comprising an infrared rays shielding material such as a metal, metal nitride, metal oxynitride, metal carbide, metal oxide or the like; or
(2) a coating film formed by a process including the step of applying a coating composition containing an infrared rays shielding material and a binder.

The film (1) can be formed by a dry process such as vacuum deposition, sputtering, ion plating, CVD or the like, or a wet process such as spraying, pyrolysis, sol-gel method and coating. The film (1) is generally formed by a dry process, pyrolysis or sol-gel method. The film (2) is formed by coating.

The film (1) is particularly preferably a metal oxide thin film essentially composed of at least one type of metal atoms selected from the group consisting of tin, indium, zinc, cadmium and titanium and having excellent infrared rays shielding properties.

The film (1) may be amorphous or crystalline.

The infrared rays shielding material used in the film (2) is preferably fine particles of a metal oxide having excellent infrared rays shielding properties named for the film (1)

Hereinafter, the metal oxide preferably used in the films (1) and (2) is described.

The metal oxide is an indium oxide-based oxide (a) containing indium oxide and (a tetravalent metal element and/or F), tin oxide-based oxide (b) containing tin oxide and (a pentavalent metal element and/or F), zinc oxide-based oxide (c) containing zinc oxide and (at least one element selected from trivalent metal elements such as metal atoms of the group IIIB, trivalent metal elements such as metal atoms of the group IVB, tetravalent metal elements, F and C), cadmium stannate (d) or the like.

The indium oxide-based oxide (a) containing indium oxide and (a tetravalent metal element and/or F) can be an oxide containing indium oxide and tin which is a tetravalent metal element. The ratio of the contained element to indium in the metal oxide-based material is preferably 0.1 to 20 atomic %.

The tin oxide-based oxide (b) containing tin oxide and (a pentavalent metal element and/or F) can be an oxide containing tin oxide and antimony which is a pentavalent metal element. The ratio of the contained element to tin in the metal oxide-based material is preferably 0.1 to 20 atomic %.

The zinc oxide-based oxide (c) containing zinc oxide and (at least one element selected from metal elements of the group IIIB, trivalent metal elements such as metal elements of the group IVB, tetravalent metal elements, F and C) can be an oxide containing zinc oxide and at least one selected from the group consisting of metal elements of the group IIIB such as Al, Ga, In and Tl, metal elements of the group IVB such as Si, Ge, Sn and Pb, and trivalent and/or tetravalent metal elements such as Ti, V, Cr, Mn, Fe, Co, Zr, Hf and La. The ratio of the contained element to zinc in the metal oxide-based material is preferably 0.1 to 20 atomic %.

The films (1) and (2) are preferably made from a zinc oxide-based oxide because it is inexpensive. The zinc oxide-based oxide is particularly preferably a zinc oxide-based oxide containing at least one element selected from metal atoms of the group IIIB and metal atoms of the group IVB because it is excellent in the transmission of a photoelectric conversion effective wavelength range and infrared rays shielding properties.

The zinc oxide-based oxide is also preferred because it can provide an ultraviolet rays shielding function to suppress the deterioration of a material forming a photoelectric conversion element, for example, a transparent electrode material such as ITO and a sealing resin by ultraviolet rays by changing the type and quantity of a metal element added.

Out of these metal oxide fine particles, particularly preferred are zinc oxide-based fine particles containing zinc oxide and at least one metal element selected from metal atoms of the group IIIB and metal atoms of the group IVB and essentially composed of a metal oxide showing metal oxide crystalline structure according to X-ray diffraction because it is inexpensive.

Hereinafter a method for producing the above zinc oxide-based fine particles having a particle size of 0.1 $\mu$m or less is described. However, it is to be understood that the present invention is not limited to this method.

To produce the zinc oxide-based fine particles, a mixture (m) of a zinc source and monocarboxylic acid dissolved or dispersed in a medium formed from at least an alcohol is maintained at a temperature of $100^{\circ}C$ or more in the presence of a compound containing at least one element selected from the group consisting of metal elements of the group IIIB and metal elements of the group IVB (may be referred to as "metal (M)" hereinafter) (This compound includes simple metals and metal alloys conceptionally. It may be referred to as "metal (M) compound" hereinafter) to deposit zinc oxide-based fine particles composed of a crystalline coprecipitation product of a metal oxide containing 80 to 99.9 atomic % of zinc and 0.1 to 20 atomic % of metal (M).

The zinc source is converted into zinc oxide which is crystalline according to X-ray diffraction by heating the mixture (m) containing monocarboxylic acid and an alcohol. At this point, a dispersion containing the zinc oxide-based fine particles can be obtained due to the presence of the metal (M) compound in the medium. If any one of the zinc source, monocarboxylic acid and alcohol is missing as a starting material, the deposition reaction of the zinc oxide crystals does not take place and the zinc oxide-based fine particles cannot be obtained without the metal (M).

When the infrared rays shielding metal oxide in the present invention is fine particles such as metal oxide fine particles, their surfaces may be modified to enhance dispersibility into a coating and chemical resistance and suppress or prevent the catalytic activity of the metal oxide. For example, the surfaces of the metal oxide fine particles may be treated with an inorganic substance such as an inorganic oxide exemplified by silica, alumina and the like, or treated with an organometallic compound such as a silicate compound exemplified by alkyltrimethoxysilane, an aluminum chelate compound or a silane, aluminate, titanate or zirconate-based coupling agent, an anionic, cationic, amphoteric or nonionic surfactant, or a polymer.

Illustrative examples of such polymer include polymers having at least one main chain selected from the group consisting of (meth)acryl, styrene, vinyl and copolymer thereof, alkyd, polyester and polyamide chains and at least one polar atomic group selected from the group consisting of carboxyl group, amino group, amide group, silanol group and alkoxysilyl group.

The morphology such as shape and particle diameter of the metal oxide fine particle are not particularly limited.

The shape of the metal oxide fine particle may be spherical, oval, cubic, rectangular parallel-piped, pyramid-like, needle-like, columnar, bar-like, cylindrical, or sheet-like such as flake-like or (hexagonal) plate-like.

Further, to achieve excellent transmission of light having a photoelectric conversion effective wavelength range and infrared rays shielding properties, the diameter of the primary particle is preferably 1 to 50 nm (0.001 to 0.05 $\mu$m). Particularly preferably, the primary particles do not form a secondary aggregate and are dispersed in a coating.

The term "primary particle diameter" as used herein means a particle size based on specific surface area D defined by the following equation:

$$D = 6/\rho S$$

wherein:

D: particle size based on specific surface area of a fine particle ($\mu$m);
$\rho$: true specific gravity of the fine particle (-);
S: specific surface area of the fine particle measured by a B.E.T. method ($m^2/g$).

The average particle diameter d of the infrared rays shielding material dispersed (average dispersion particle diameter) is preferably 1 $\mu$m or less to achieve high transparency and infrared rays shielding efficiency and eliminate its influence on the hue of a composition obtained by adding the material to the composition. The average particle diameter d is more preferably 0.5 $\mu$m or less, much more preferably 0.1 $\mu$m or less, particularly preferably 0.05 $\mu$m or less. The ratio R (= d/D) of the average particle diameter d to the primary particle diameter D is preferably 2 or less, more preferably 1.5 or less, particularly preferably 1.2 or less.

The dispersion average particle diameter is an average particle diameter based on weight which can be measured by a dynamic light scattering method or centrifugal precipitation method. When the average particle diameter is less than 0.1 $\mu$m, it is measured by the dynamic light scattering method and when the particle diameter is 0.1 $\mu$m or more, it is measured by the centrifugal precipitation method.

The metal oxide fine particle may be amorphous or crystalline. To achieve infrared rays shielding properties, it is preferably a fine particle which is crystalline according to X-ray diffraction or a fine particle which is amorphous when it is contained in a coating but crystalline after the formation of a film.

When the fine particle is crystalline, its crystallite size is preferably 1 to 50 nm for the same reason as that of the above-described primary particle diameter.

The crystallite size means an average value of a crystallite size measured by the powder X-ray diffraction measurement of the fine particle powder and obtained form a diffraction angle and the broadening of diffraction profile corresponding to crystallite size using a Scherrer's equation.

The composition of a coating composition in the film (2) may be any composition if it contains the above-described infrared shielding material. It generally contains at least a binder component which can form a coating film by binding the infrared rays shielding material and a solvent component in addition to the infrared rays shielding material.

In the present invention, the infrared rays shielding material is contained in an amount of 1 to 90 wt% and the binder component in an amount of 99 to 10 wt% based on the total weight of the infrared rays shielding material and the binder component. The weight ratio of the total of the infrared rays shielding material and the binder component to the total weight of the composition is preferably 10 to 90 wt%, more preferably 30 to 90 wt%.

The binder is not limited to a particular one. Any conventionally known binder may be used. Illustrative examples of the binder include organic binders such as thermoplastic polymer, thermosetting, moisture curable, ultraviolet curable and electron beam curable resins, including (meth)acrylic polymer, (meth)acryl urethane polymer, (meth)acryl silicone polymer, alkylpolysiloxane polymer, polyvinyl chloride, polyvinylidene chloride, melamine polymer, urethane polymer, styrene polymer, alkyd polymer, phenol polymer, epoxy polymer and polyester, and fluoropolymer such as polyvinylidene fluoride and fluoroolefin vinyl ether polymers, synthetic rubbers including ethylene-propylene copolymer rubber, polybutadiene rubber, styrene-butadiene rubber and acrylonitrile-butadiene rubber, natural rubber, and the like; and inorganic binders such as silica sol, alkali silicate, silicon alkoxide, (hydrolysis) condensates thereof, phosphates and the like.

In the category of the above binder are also included ultraviolet curable (meth)acrylic resins which have been known as a hard coat resin, thermosetting and moisture curable ((meth)acrylic)silicone resins, pure silicone resins which are used as a heat-resistant coating, and modified silicone resins such as silicone alkyd resins, silicone urethane resins, silicone polyester resins and silicone acrylic resins.

These binders may be used alone or in admixture of two or more.

Out of the above binders, (meth)acryl-based polymer binders, (meth)acryl urethane-based binders, (meth)acryl silicone-based polymer binders, pure silicone polymer binders, modified silicone polymer binders such as silicone alkyd polymer, silicone urethane polymer, silicone-polyester polymer and silicone-acrylic polymer binders, fluoropolymer binders such as polyvinylidene fluoride and fluoroolefin vinyl ether copolymer binders are preferred. At least one out of these binders is preferably contained in an amount of 50 wt% or more based on the total weight of binders.

The above infrared rays shielding material and binder component are generally dissolved, emulsified or suspended in a solvent.

The solvent for coatings is not limited to a particular one and suitably selected according to the application purpose of the coating composition and the type of a binder. Illustrative examples of the solvent include organic solvents such as alcohols, aliphatic and aromatic carboxylic acid esters, ketones, ethers, ether esters, aliphatic and aromatic hydrocarbons and hydrocarbon halides, water, mineral oil, vegetable oil, wax oil, silicone oil and the like. Two or more of these solvents may be mixed in a desired ratio as required.

The above coating is applied to a substrate, and heated or irradiated with an electron beam as required for the purpose of curing or crosslinking to form an infrared rays shielding film.

The coating method is not particularly limited and may be any known method such as dipping, spraying, screen printing, roll coating, flow coating or the like.

The infrared rays shielding film may be formed directly on a photoelectric conversion element by coating as described above or a preformed film product may be used. In the latter case, the substrate is not particularly limited but is preferably a film, sheet or plate of a plastic such as polyester, polyolefin, polycarbonate, (meth)acrylic based polymer resin or fluoropolymer resin, or glass because they have high transmission of visible rays and excellent weatherability.

In the present invention, after a coating composition is applied to form a coating film, the coating film is preferably cured or cross-linked by heat (including room temperature curing), moisture, ultraviolet rays or electron beam to form a cured or cross-linked film from a viewpoint of chemical resistance properties such as water resistance, solvent resistance, acid resistance and alkali resistance, and scratch resistance.

When a film is formed by coating directly on a photoelectric conversion element which consists of a metal electrode, silicon layer and transparent electrode on an insulated substrate, the infrared rays shielding coating film can be formed on the surface of the transparent electrode directly or through a transparent intermediate layer. Alternatively, when the photoelectric conversion element consists of a transparent electrode, silicon layer and metal electrode formed on a transparent substrate such as glass, the infrared rays shielding film may be formed on the transparent substrate or between the transparent substrate and the transparent electrode as an intermediate layer.

When the photoelectric conversion element is sealed with a transparent resin, the infrared rays shielding film may be formed on the surface of the sealing resin.

Another method for producing the infrared rays shielding film in the present invention comprises preparing a resin composition containing the above infrared rays shielding material by mixing it with a powder resin such as a polyester, polycarbonate, polyolefin and the like, and melting and kneading these, forming the composition into a sheet or film and drawing it as required to obtain the infrared rays shielding film of the present invention.

Alternatively, the infrared rays shielding film in the present invention can be obtained by dispersing or dissolving the infrared rays shielding material in a polymerizable monomer such as a (meth)acryl monomer and cast polymerizing.

The infrared rays shielding film in the present invention can be mixed with an ultraviolet rays shielding agent having an ultraviolet rays shielding function in order to suppress the deterioration of materials constituting the photoelectric conversion element, for example, a transparent electrode material such as ITO and a sealing resin, by ultraviolet rays, or prevent the deterioration of the infrared rays shielding film itself by ultraviolet rays. Alternatively, a film containing an ultraviolet rays shielding agent or the like may be formed on or under the infrared rays shielding film separately.

Illustrative examples of the effective ultraviolet rays shielding agent include materials having a function to shield rays having a wavelength of 300 to 400 nm, particularly 320 to 380 nm, such as organic ultraviolet rays absorbers exemplified by salicylic acid-based, benzophenone-based, benzotriazole-based and cyanoacrylate-based absorbers, and ultraviolet absorbing and/or scattering metal oxides such as titanium oxide, zinc oxide and cerium oxide. When the metal oxide is in the form of fine particles, the average particle diameter of its primary particles is preferably 0.1 $\mu$m or less, more preferably 0.05 $\mu$m or less, particularly preferably 0.02 $\mu$m or less from a view point of transmission of visible rays.

Further, hindered amine-based compounds, benzoate-based compounds, nickel complex-based compounds such as nickel bis(octylphenyl)sulfide which are known as ultraviolet rays stabilizers and optical stabilizers may be added or used in conjunction with the above ultraviolet rays shielding agent.

In addition, the infrared rays shielding film in the present invention may contain such conventionally known additives as an antioxidant and the like as required.

The photoelectric conversion element of the present invention is mainly used in outdoor solar cells which generate power by sunlight and indoor solar cells, for example, solar cells for generating power by sunlight (including solar cells for private use), solar cell roof tiles, solar cell tiles, structures and car windows which function to cut out infrared rays, see-through solar cells such as sun roofs, radio relay power sources, communication satellite power sources, card type desktop calculators, radios with solar cells, traffic signals, mail posts, street lights, optical batteries for independent power sources for TVs, solar cars, solar airplanes, solar boats, solar refrigerators, solar cells for pressing solar cans, holograms and the like.

(Advantages of the invention):

According to the present invention, by forming a film for cutting out infrared rays including a heat ray (infrared rays shielding film) which causes a temperature rise while it has excellent transmission of light having a wavelength range to which silicon, particularly amorphous silicon is sensitive, on a light input side of a photoelectric conversion element, a temperature rise in the photoelectric conversion element is suppressed and the photoelectric conversion element can be protected from rain, steam, wind and the like.

Further, since the infrared rays shielding film contains an infrared rays reflective and/or absorptive material, the object of the present invention can be attained by a single layer. Therefore, the infrared rays shielding film is much more economical than a multi-layer infrared rays shielding film. In addition, since a film forming method can be selected according to physical properties such as heat resistance, chemical resistance and solvent resistance of the material forming the film, it has such an advantage that its application range is very wide.

Consequently, the photoelectric conversion element of the present invention is a silicon photoelectric conversion element which is rarely affected by environmental changes, suppresses a reduction in output and has high and stable photoelectric conversion characteristics without impairing its economic advantage.

## DETAILED DESCRIPTION OF THE PREFERRED EMBODIMENTS

Hereinafter, the present invention is illustrated in more detail by the following examples of some preferred embodiments in comparison with comparative examples not according to the invention. However, it is to be understood that the present invention is not limited to these examples.

Evaluations were made in accordance with the following methods in the examples.

〈 Crystallinity 〉

This is evaluated by powder X-ray diffraction.

〈 Crystallite size 〉

A powder sample is measured by powder X-ray diffractometry to obtain average crystallite size from Bragg angle $\theta$ ($2\theta$: diffraction angle) and the broadening of diffraction profile corresponding to crystallite size $\beta$ using the following Scherrer's equation:

$$Dc = K\lambda/\beta\cos\theta$$

wherein:

Dc: crystallite size of the sample (nm);
K: Scherrer's constant (equipment constant);
$\lambda$: wavelength of incident X-ray (nm);
$\beta$: the broadening of diffraction profile corresponding to crystallite size (radian), to put it in the concrete, integral width of diffraction profile showing highest peak intensity in diffraction pattern of the sample;
$\theta$: Bragg angle ($2\theta$ : diffraction angle) (°).

〈 Primary particle diameter 〉

The primary particle diameter, that is, particle size based on specific surface area, is calculated from a specific surface area measured by a B.E.T. method using the following equation:

$$D = 6/\rho s$$

wherein:

D: particle size based on specific surface area of a fine particle ($\mu$m);
$\rho$: true specific gravity of the fine particle (-);

S:  specific surface area of the fine particle measured by a B.E.T. method ($m^2$/g).

〈Average dispersion particle diameter〉

A coating is diluted with a solvent as required and the average particle diameter based on weight is obtained using a particle diameter analyzer (NICOMP Autodilute Submicron Particle Sizer Model 370 of Nozaki Sangyo Co., LTD.) by a dynamic light scattering method and taken as an average dispersion particle diameter.

〈Composition of fine particle〉

This is obtained using a powder sample by X-ray fluorescence analysis, atomic absorption spectrometry, thermogravimetry and elemental analysis.

〈Haze〉

This is measured using a turbidimeter (NDH-1001 DP of Nippon Denshoku Co.).
Haze data provided in each example is a value of a film product unless otherwise stated. A measurement method and a calculation method are shown below when it shows a value of a film itself.

(1) Air is based (air: a haze of 0 %).
(2) The haze of a substrate is measured and represented by Ho (%).
(3) The haze of a film formed on a substrate is measured and represented by $H_s$ (%).
(4) The haze of the film is calculated from the following equation.

$$H\ (\%) = H_s - H_o\ (\%)$$

When $H_s \leq H_o$, H = 0 (%).

〈Optical properties of coated product〉

As for spectral characteristics, the transmittance of light having a wavelength range of 2,500 to 200 nm is measured and evaluated using UV-VIS-NIR Recording spectrophotometer (UV-3100 of Shimadzu Corp.) in which an integrating sphere attachment accessory unit (ISR-3100 of Shimadzu Corp.) is installed in a sample chamber.
The average transmittance of the following wavelength ranges is calculated from the above measured spectral transmittances.

$TV_1$: average transmittance of light having a wavelength of 380 nm to 1 μm
$TV_2$: average transmittance of light having a wavelength of 380 to 780 nm
$TIR_1$: average transmittance of light having a wavelength of 1 to 2 μm
$TIR_2$: average transmittance of light having a wavelength of 1 to 1.5 μm

The term "average transmittance of each wavelength range" as used herein means the ratio of the total quantity of transmitted light to the quantity of incident light having a predetermined wavelength range.
Ultraviolet rays shielding properties are evaluated according to the following definition.

TUV: average transmittance of light having a wavelength of 320 to 380 nm
T350 nm: transmittance of light having a wavelength of 350 nm

Data on the transmittance of each wavelength range shown in each example and data as T350 are values of film products unless otherwise stated. A measurement method and calculation method are described below when the values are values of films themselves.

(1) Air is based (transmittance of each wavelength in the air is set as 100%).
(2) A film having the same composition as a film formed on a substrate in each example and a thickness of 320 nm to 2 μm is formed on a transparent quartz glass plate and the spectral transmittance of a light having a wavelength of 320 nm to 2 μm of this film product is measured. The transmission area Ss of each wavelength range is obtained.

$S_s(TV_1)$, $S_s(TV_2)$, $S_s(TIR_1)$, $S_s(TIR_2)$, $S_s(TUV)$

(3) The spectral transmittance of the above quartz glass plate is measured to obtain the transmission area of each wavelength range So.

$S_o(TV_1)$, $S_o(TV_2)$, $S_o(TIR_1)$, $S_o(TIR_2)$, $S_o(TUV)$

(4) The average transmittance of each wavelength range of each film is calculated from the following equations.

$$TV_1 = S_s(TV_1) / S_o(TV_1)$$

$$TV_2 = S_s(TV_2) / S_o(TV_2)$$

$$TIR_1 = S_s(TIR_1) / S_o(TIR_1)$$

$$TIR_2 = S_s(TIR_2) / S_o(TIR_2)$$

$$TUV = S_s(TUV) / S_o(TUV)$$

As for T350 (transmittance of light having a wavelength of 350 nm), the transmittance $T350_o$ of light having a wavelength of 350 nm of the quartz glass plate and the transmittance $T350_s$ of light having a wavelength of 350 nm of a film product obtained by forming a film on a quartz glass plate are obtained from the following equation.

$$T350 = T350_s / T350_o$$

Comparative Example 1

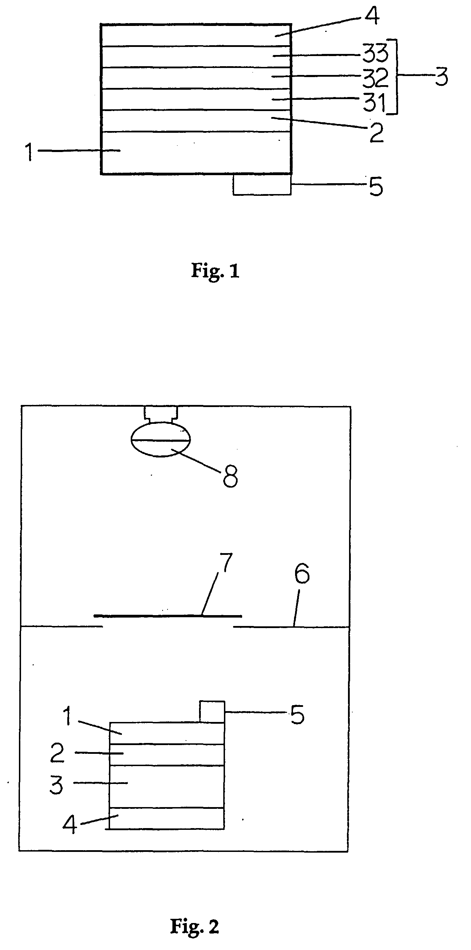

A PIN type photoelectric conversion element as shown in Fig. 1 which consisted of a transparent conductive film (ITO film) 2, amorphous silicon film 3 (p-type amorphous silicon film 31, i-type amorphous silicon film 32, n-type amorphous silicon film 33), and aluminum electrode 4 formed on a transparent glass plate (glass substrate) 1 in the mentioned order and which had a black panel thermometer on the surface on the glass substrate 1 was set in a measuring instrument equipped with a lamp 8 (RF100 (110) V270W type for indoor illumination of Iwasaki Denki Co.) in such a manner that the glass substrate 1 faced up and the aluminum electrode 4 faced down as shown in Fig. 2.

Further, a 100 μm-thick PET film was set on a sample base 6 made from a transparent acryl plate as a film 7 in a thermo-hydrostat having a temperature of 22°C and a relative humidity of 60% as shown in Fig. 2 and time changes in the temperature of the surface (black panel thermometer) of the element were measured when the lamp was turned on.

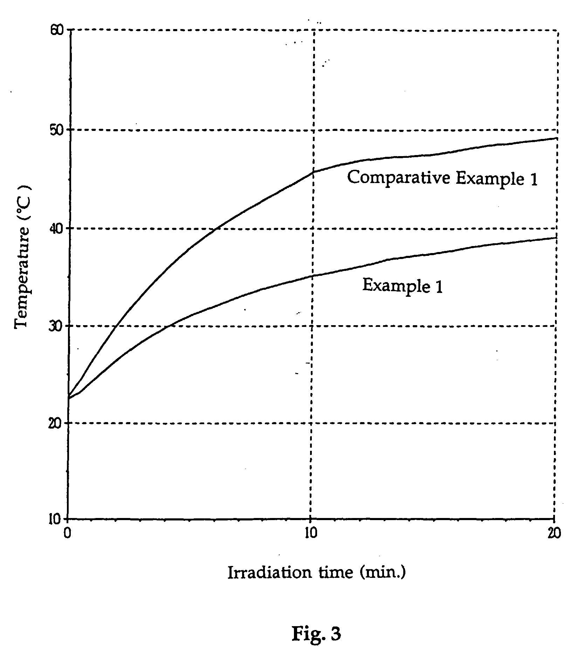

The results are shown in Fig. 3.

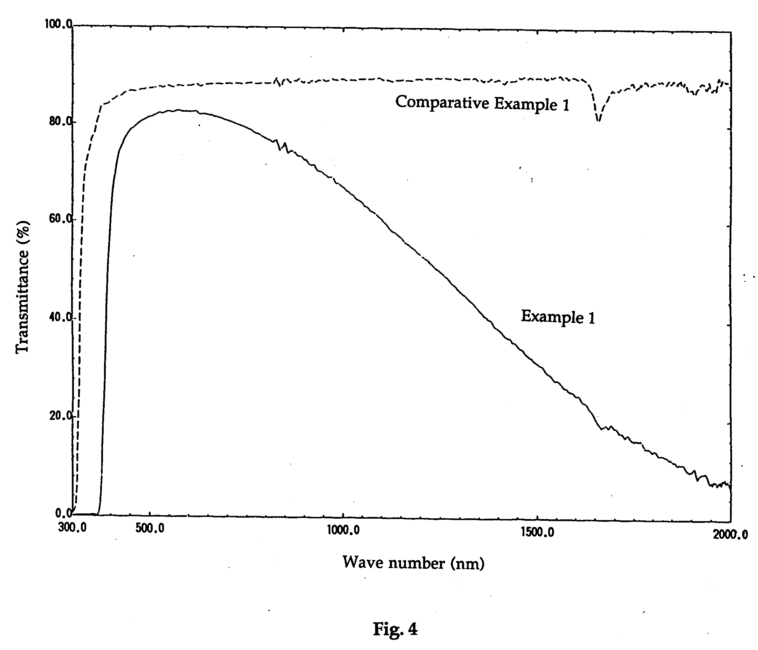

The spectral transmittance curve of the PET film is shown in Fig. 4 and its optical properties are shown in Table 1.

Example 1

A coating comprising 30 wt% of ZnO fine particles (ZnO(Al) fine particles) containing Al having an average primary particle diameter of 10 nm and an average crystallite size of 8 nm, 10 wt% of an acrylic resin binder and 60 wt% of a toluene-MEK (2:1) mixture solvent was applied to the same PET film as in Comparative Example 1 and dried to obtain a 5 μm-thick ZnO(Al) dispersed coating film (film A). The average dispersion particle diameter of ZnO particles in the coating was 12 nm.

The spectral transmittance curve of the film A is shown in Fig. 4 and its optical properties are shown in Table 1.

Thereafter, the same device as in Comparative Example 1 was used to measure time changes in the temperature of the surface of the element as in Comparative Example 1 except that the film A was used in place of the PET film as film 7.

The results are shown in Fig. 3.

Table 1

| | Used film | $TV_1$ | $TV_2$ (%) | $TIR_1$ (%) | $TIR_2$ (%) | Haze Value |
|---|---|---|---|---|---|---|
| Comparative Example 1 | PET film | 88 | 87 | 89 | 90 | 2 |
| Example 1 | ZnO(Al) dispersion film coated PET film | 76 | 78 | 34 | 50 | 2.5 |
| | Value of film | 87 | 90 | 38 | 55 | 0.5 |

Examples 2 to 4 and Comparative Examples 2 and 3

Changes in the temperature of the glass case were measured using the same device as in Comparative Example 1 in the same manner as in Comparative Example 1 except that films and glass shown in Table 2 were used in place of the PET film as film 7. The measurement results are evaluated based on the following criteria. The evaluation results are shown in Table 3.

Evaluation method

O: A temperature rise after 10 minutes is less than 15$^{\circ}$C.
X: A temperature rise after 10 minutes is 15$^{\circ}$C or more.

Table 2

|  | substrate | formed film | film formation method |
|---|---|---|---|
| Comparative Example 2 | PET film | none | - |
| Comparative Example 3 | PET film | SiO$_2$ thin film | vapor deposition |
| Example 2 | tetrafluoroethylene-ethylene copolymer resin film | ITO thin film (Sn-containing In$_2$O$_3$) | vapor deposition |
| Example 3 | glass | B-containing ZnO thin film | sputtering |
| Example 4 | polycarbonate sheet | Sb-containing SnO$_2$ dispersion film | coating |

Table 3

|  | Value of film itself | | | | Haze value of film itself | Temperature change |
|---|---|---|---|---|---|---|
|  | TV$_1$ (%) | TV$_2$ (%) | TIR$_1$ (%) | TIR$_2$ (%) |  |  |
| Comparative Example 2 | 88 | 90 | 89 | 90 | 2 | x |
| Comparative Example 3 | 87 | 89 | 88 | 87 | 0.2 | x |
| Example 2 | 88 | 91 | 15 | 29 | 0 | O |
| Example 3 | 89 | 90 | 36 | 50 | 3 | O |
| Example 4 | 87 | 89 | 34 | 53 | 0.8 | O |

Example 5

The output characteristics of a trade amorphous silicon solar cell module (sealed by a glass plate) for indoor use were evaluated when it was left outdoors.

Changes in output P were measured for 1 hour when the module and the module having each of films shown in Tables 4, 5 and 6 on the surface of the glass of the light incident side of the module and each of acrylic adhesive films on the other side were left outdoors at the same times. The temperature rose by 1$^{\circ}$C.

As a result, the module having an adhesive film saw smaller changes in voltage and current and a smaller reduction in output than the module having no adhesive film.

When the films (1) to (3) were compared in output value, the film (1) was the most effective.

When the modules having the adhesive films (1) to (5) were operated for six months while they were left outdoors, it was confirmed that substantial changes in optical properties such as transmittance, haze value and spectral transmittance of the films (1), (2), (4) and (5) were not observed and no films peeled off. However, the film (3) peeled off.

Table 4

| Compositions of infrared rays shielding films used in Example 5 | | | | |
|---|---|---|---|---|
| | fine particle | binder (main) | curing method | curing agent |
| (1) | In-containing ZnO | fluoroethylene vinylether polymer | urethane crosslinking | isocyanurate |
| (2) | Ga-containing ZnO | acryl silicone polymer | moisture curing | dibutyltin dilaurate |
| (3) | Sb-containing $SnO_2$ | acrylpolyol | urethane crosslinking | isocyanurate |
| (4) | Sb-containing $SnO_2$ | Acrylic polymer | ultraviolet curing | - |
| (5) | Sn-containing $In_2O_3$ | Polyester polymer | none | none |
| (6) | Sn-containing $In_2O_3$ | Cohydrolyzed and condensed polymer of mixture of TEOS and MTMS | moisture curing | ethanolamine |
| TEOS: tetraethoxysilane MTMS: methyltrimethoxysilane | | | | |

Table 5

| Physical properties of fine particles | | | | | | |
|---|---|---|---|---|---|---|
| | composition of metal atoms | primary particle diameter | crystallite size | crystallinity | surface treatment agent | ultraviolet rays shielding agent added |
| (1) | In/ Zn=3mol% | 12 | 11 | ○ | decyltrimethoxysilane | ZnO[*1] HALS[*2] |
| (2) | Ga/ Zn=2mol% | 40 | 23 | ○ | dimethyldimethoxysilane | - |
| (3) | Sb/ Sn=8mol% | 12 | 11 | ○ | alkylacetoacetate aluminum diisopropylate | - |
| (4) | Sb/Sn= 2.5mol% | 5 | 6 | ○ | - | tinuvin P[*3] |
| (5) | Sb/In= 0.5mol% | 10 | 10 | ○ | - | - |
| (6) | Sb/In= 8mol% | 8 | 5 | ○ | - | tinuvin P[*4] HALS[*2] |

*1 methyltrimethoxysilane treated ZnO ultra fine particle (primary particle diameter of 8 nm)
amount of addition ZnO/In-containing ZnO = 10 wt%
*2 HALS: hindered amine-based optical stabilizer
amount of addition: HALS/coating = 0.5 %
*3 tinuvin P: 2-(5-methyl-2-hydroxyphenyl)benzotriazole (benzotriazole-based ultraviolet absorber of Nippon Ciba Geigy)
amount of addition: tinuvin P/Sb-containing $SnO_2$ = 1 %
*4 amount of addition: tinuvin P/Sb-containing $In_2O_3$ = 5 %

Table 6

| | TV$_1$ (%) | TV$_2$ (%) | TIIR$_1$ (%) | TIIR$_2$ (%) | Haze value | TUV (%) | T350 (%) |
|---|---|---|---|---|---|---|---|
| | | | Physical properties of film itself | | | | |
| (1) | 93 | 96 | 8 | 16 | 0.1 | 0.8 | 1.1 |
| (2) | 75 | 80 | 50 | 67 | 8 | 0.8 | 0 |
| (3) | 78 | 85 | 12 | 23 | 0.6 | 73 | 54 |
| (4) | 87 | 89 | 34 | 53 | 0.2 | 15 | 3 |
| (5) | 92 | 95 | 21 | 41 | 0.3 | 68 | 71 |
| (6) | 81 | 86 | 9 | 19 | 0.6 | 3 | 0.1 |

Reference Example (production of ZnO-based ultra fine particle (Zn-In coprecipitated oxide particle) (1) of Example 5)

0.14 kg of anhydrous zinc acetate powders, 0.24 kg of zinc oxide powders and 0.036 kg of indium acetate 2-hydrate were added to and mixed with a mixture solvent containing 2.0 kg of acetic acid and 1.5 kg of ion exchange water in a 10-liter glass reactor equipped with a stirrer, drop port, thermometer and reflux cooler, and heated to 100 °C under agitation to obtain a uniform solution of zinc (Al).

Thereafter, 20 kg of 2-butoxyethanol was charged into a 20-liter SUS reactor equipped with a stirrer, drop port, thermometer and distillation gas outlet, heated to 150°C and maintained at that temperature. The total amount of the zinc-containing solution (Al) maintained at 100°C was added dropwise to the 2-butoxyethanol and the inside of the reactor was heated to 160°C. After 0.04 kg of lauric acid was added, the resulting mixture was heated and maintained at 160°C for 10 hours to obtain a dark blue dispersion (B). The obtained dispersion (B) contained fine particles having a primary particle diameter of 12 nm dispersed therein. The fine particles contained in the dispersion (B) were crystalline zinc oxide according to X-ray diffraction and zinc and indium coprecipitated oxide fine particles comprising 95 wt% of a metal oxide and 3.0 atomic % of In based on the total amount of metal atoms.

After the dispersion (B) was cooled, a toluene solution containing 0.06 kg of decyltrimethoxysilane was added under agitation and stirred at room temperature for 24 hours. The resulting solution was subjected to centrifugal separation and dispersed into MEK to obtain a MEK dispersion of zinc and indium coprecipitated oxide fine particles whose surfaces were treated with decyltrimethoxysilane.

The MEK dispersion was mixed with a fluoroethylene vinylether polymer solution and stirred, and then a curing agent was added to obtain a coating used in (1) of Example 5.

Various details of the invention may be changed without departing from its spirit not its scope. Furthermore, the foregoing description of the preferred embodiments according to the present invention is provided for the purpose of illustration only, and not for the purpose of limiting the invention as defined by the appended claims and their equivalents.

## Claims

1. A photoelectric conversion element, comprising photoelectric conversion cells each of which has at least two electrodes and a silicon layer as electrically connected to said electrodes, with the photoelectric conversion element being characterized in that an infrared rays shielding film containing an infrared rays reflective and/or absorptive material is formed on a light input side of said photoelectric conversion element.

2. A photoelectric conversion element according to claim 1, wherein said infrared rays reflective and/or absorptive material is a metal oxide.

3. A photoelectric conversion element according to claim 1 or 2, wherein said infrared rays shielding film is a coating film which is obtained by a process including the step of applying a coating composition including an infrared rays reflective and/or absorptive material and a binder.

4. A photoelectric conversion element according to claim 3, wherein said coating film is a film cured by at least one of heat, moisture, electron beam and ultraviolet rays after the application of said coating composition.

**Fig. 1**

**Fig. 2**

Fig. 3

Fig. 4